# FASCICULE DE BREVET EUROPEEN

(11) **EP 0 527 359 B1**
(45) Date de publication et mention de la délivrance du brevet: **15.10.1997**
(21) Numéro de dépôt: 92112420.2
(22) Date de dépôt: 21.07.1992
(51) Int. Cl.: H01L 23/40, H05K 7/20

(54) **Dissipateur thermique**
Wärmeableiter
Heat sink

(30) Priorité: 23.07.1991 FR 9109281
(43) Date de publication de la demande: 17.02.1993
(73) Titulaire: ALCATEL TELSPACE, 92734 Nanterre Cédex (FR)
(72) Inventeur: Rio, Pascal, F-92270 Bois Colombes (FR); Magnenet, Patrick, F-77400 Thorigny sur Marne (FR)
(74) Mandataire: Scheer, Luc

(56) Documents cités:
- EP-A- 0 048 938
- DE-A- 3 203 609
- GB-A- 2 163 598

## Description

Le domaine de l'invention est celui des dissipateurs thermiques destinés à évacuer l'énergie calorifique dissipée par des composants électroniques.

De façon connue, le refroidissement de composants électroniques entrant dans la réalisation d'une fonction, tel que les transistors, thyristors, triacs, ponts de diodes, et généralement tout composant dissipant une certaine quantité d'énergie calorifique, est réalisé de manière déportée, c'est-à-dire en plaçant ces composants sur des dissipateurs non compris sur la carte électronique comportant les autres composants d'un montage. Les composants sont alors reliés à la carte à l'aide de fils. Ces dissipateurs peuvent alors être de taille importante et fixés à l'extérieur d'un boîtier, par exemple sur sa face arrière.

Cependant, dans le cas où ces composants ne sont pas déportables, il est nécessaire de prévoir des emplacements sur la carte électronique pour pouvoir y disposer de tels dissipateurs. Ces composants sont par exemple des circuits intégrés dissipant plusieurs watts, par exemple des ASIC (circuits intégrés conçus spécialement pour une application) de type prédiffusé. Il peut également s'agir de composants passifs tels que des résistances de puissance que l'on ne peut pas ou que l'on ne veut pas déporter, par exemple pour éviter de tirer des fils de connexion.

Les dissipateurs utilisés présentent généralement un encombrement important sur la carte.

On connaît également des dissipateurs thermiques montés directement sur les circuits intégrés à refroidir, afin de limiter cet encombrement. La demande de brevet allemande n° 32.03.609 au nom de SIEMENS décrit un tel dissipateur thermique pour circuit intégré. Ce dissipateur est constitué par une plaque pliée en U dont la partie centrale est appliquée contre la surface supérieure du circuit intégré, les parties latérales du U comportant des prolongements, parallèles à ces parties latérales, terminés par des pattes de fixation. Les pattes de fixation sont soudées avec des pattes du circuit intégré sur le circuit imprimé portant le circuit intégré. A l'aide d'un tel dissipateur thermique, l'encombrement sur la carte est limité puisque le dissipateur est disposé sur le composant à refroidir.

Le principal inconvénient de ce dissipateur thermique est que la surface de contact avec le circuit intégré est plane, et il existe donc un risque de mauvais refroidissement si le circuit intégré n'est pas correctement positionné sur le circuit imprimé, c'est à dire si sa surface supérieure n'est pas parallèle au circuit imprimé. Il faut donc veiller au bon positionnement du circuit intégré, ce qui est coûteux en temps et contraignant, voire impossible lorsque les composants sont soudés à la vague.

Ce type de dissipateur thermique ne convient également que pour des circuits intégrés dissipant une énergie calorifique réduite, du fait de la surface limitée présentée par le dissipateur. Il n'est en effet pas possible d'augmenter sensiblement cette surface pour dissiper plus d'énergie, du fait de l'encombrement en hauteur qui en résulterait. On observe de plus un refroidissement moins performant des circuits intégrés de taille réduite, par exemple de ceux ne comportant que 8 broches de connexion, puisque la surface de dissipation est plus réduite.

Par ailleurs, chaque dissipateur de ce type est conçu spécialement pour un circuit intégré de taille prédéterminée et il est donc nécessaire de stocker un nombre important de dissipateurs différents.

La demande de brevet britannique n°2.163.598 décrit un système de dissipation de l'énergie calorifique dégagée par un composant électronique monté sur une carte. Ce système se compose d'un dissipateur thermique constitué d'une plaque usinée en matériau thermiquement conducteur disposée au-dessus du composant à refroidir et fixée à l'aide de moyens de fixation à proximité du composant. Les moyens de fixation sont constitués par un élément élastique articulé aux extrémités de la plaque à l'aide de vis et disposé de l'autre côté de la plaque.

Ce système permet de s'affranchir d'un mauvais positionnement du composant mais comporte de nombreux inconvénients, notamment :
- l'encombrement présenté est important des deux côtés de la carte ;
- les composants mécaniques employés sont spécifiques ;
- il est nécessaire de prévoir des orifices de passage des vis et un orifice de passage d'une surface d'appui de l'élément élastique ;
- il ne s'applique qu'au refroidissement d'un composant unique.

La présente invention a notamment pour objectif de pallier ces inconvénients.

Plus précisément, un des objectifs de l'invention est de fournir un dissipateur thermique pour composants électroniques montés sur une carte qui présente un contact thermique optimal avec les composants à refroidir, quel que soit leur positionnement sur le circuit imprimé, et un encombrement faible.

Un autre objectif de l'invention est de fournir un tel dissipateur thermique ayant un coût de revient faible et assurant un refroidissement optimal de n'importe quel type de composant, quelle que soit sa taille.

Ces objectifs, ainsi que d'autres qui apparaîtront par la suite, sont atteints grâce à un dissipateur thermique tel que défini à la revendication 1.

On assure de ce fait qu'un contact thermique optimal est obtenu entre le dissipateur thermique et les composants, même si ceux-ci ne sont pas bien positionnés sur le circuit imprimé.

D'autres caractéristiques et avantages de l'invention apparaîtront à la lecture de la description suivante d'un mode de réalisation préférentiel, donné à titre illustratif et non limitatif, et des dessins annexés dans lesquels :
- la figure 1 est une vue de côté schématique partiellement coupée d'un mode de réalisation préférentiel de l'invention;
- la figure 2 est une vue de dessus schématique d'une carte électronique équipée d'un dissipateur thermique selon l'invention.

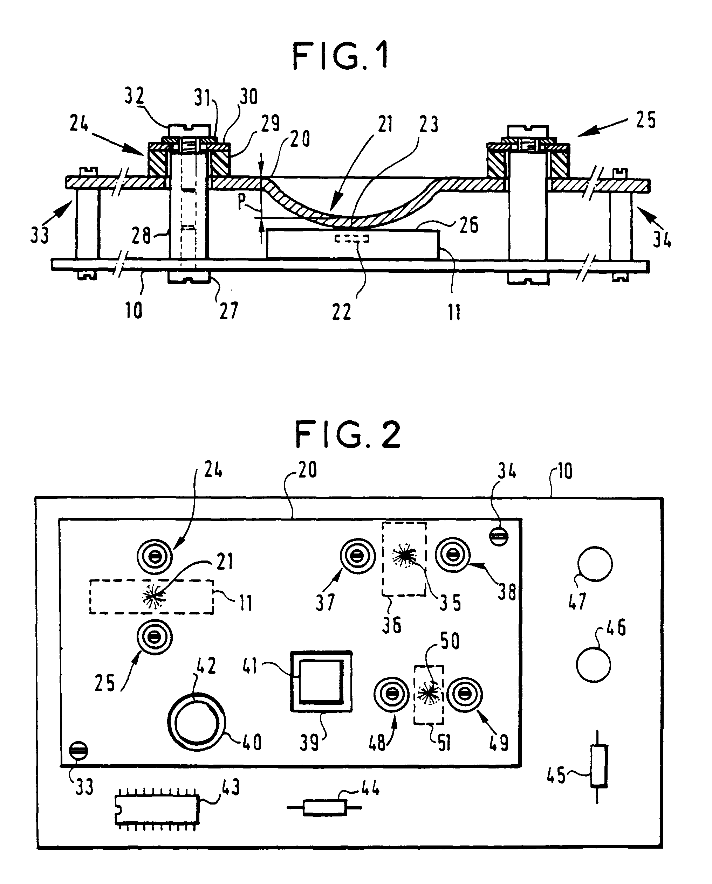

Sur la figure 1, une carte électronique 10 comporte un composant 11 dont on veut limiter l'échauffement. Une plaque 20 en matériau thermiquement conducteur est fixée au-dessus du composant 11, par exemple constitué par un ASIC de type prédiffusé. La plaque 20 comporte une déformation 21 sphérique centrée sur la puce 22 du circuit intégré 11.

La déformation 21 est par exemple réalisée par emboutissage de la plaque 20. On obtient ainsi une continuité thermique entre la déformation 21 et la plaque 20, d'où un refroidissement efficace.

Deux moyens de fixation 24,25 assurent un contact physique entre la surface supérieure 26 du circuit 11 et la surface inférieure 23 de la déformation 21. Ces moyens de fixation 24,25 sont avantageusement placés symétriquement par rapport au point de contact avec le composant 11 à refroidir et le plus près possible de celui-ci afin d'assurer un contact optimal entre la déformation 21 et le composant 11.

Chaque moyen de fixation 24,25 est constitué, selon un mode de réalisation préférentiel, d'une vis 27, d'une entretoise 28, d'une rondelle élastique 29, d'une rondelle métallique 30 et d'une autre vis 32.

Il est à noter que, selon le mode de réalisation représenté, les moyens 24 et 25 assurent uniquement un appui de la déformation 21 sur le circuit 11, la fixation de la plaque 20 à la carte 10 pouvant être assurée par des jeux entretoises-écrous 33,34. Les moyens de fixation 33,34 ont pour fonction d'équilibrer la plaque 20 si les moyens de fixation du type 24,25 affectés à chacun des composants à refroidir n'assurent pas à eux seul un maintien suffisant de la plaque 20.

Une plaque peut alors comprendre plusieurs déformations sphériques réalisées à des emplacements correspondants à des composants à refroidir disposés sur une carte recouverte par cette plaque. On exploite alors l'élasticité de la plaque due à sa faible épaisseur, de l'ordre de 1,5 millimètres, pour appliquer les déformations de la plaque sur les composants respectifs à refroidir, à l'aide de systèmes de maintien du type 24,25.

Chaque entretoise 28 est taraudée à ses deux extrémités et accueille les corps de vis 27 et 32. Chaque rondelle élastique est maintenue contre la plaque 20 à l'aide de la rondelle métallique 30 et de la vis 32. La tête de la vis 32 exerce une pression sur la rondelle 30 de diamètre sensiblement égal à celui de la rondelle élastique 29, éventuellement à travers une rondelle 31. La rondelle 31 supplémentaire peut être prévue si la tête de la vis 32 n'est pas suffisamment large pour appuyer efficacement sur la rondelle élastique 29.

A l'aide d'un jeu de deux systèmes de fixation de ce type, disposés de part et d'autre du composant 11 à refroidir, il est possible d'optimiser au mieux la pression exercée par la déformation 21 sur le composant 11. Une pression adaptée au composant permet en effet d'obtenir une liaison thermique adéquate entre le composant à refroidir et la plaque servant de dissipateur thermique, tout en évitant d'appliquer une pression trop forte qui endommagerait ce composant. La possibilité de réglage de cette pression est fournie par les rondelles élastiques.

Lorsque les composants à refroidir sont proches les uns des autres sur le circuit 10, trois systèmes de fixation à rondelles élastiques peuvent suffire pour assurer un contact thermique entre les composants et la plaque. Un système de fixation à rondelle élastique est alors commun à deux composants à refroidir et disposé entre ceux-ci.

Selon un mode de réalisation, la hauteur des entretoises 28 est différente selon la taille du ou des composants à refroidir.

Selon un mode de réalisation pouvant être complémentaire, la profondeur P de chaque déformation est calculée suivant la taille du composant à refroidir. Un dissipateur thermique de ce type se présente alors sous la forme d'une plaque comportant autant de déformations qu'il y a de composants à refroidir, chaque déformation ayant une profondeur adaptée à la taille du composant sur laquelle elle vient s'appliquer. Les surfaces inférieures 23 des déformations sont avantageusement centrées sur les sources calorifiques des composants. Dans le cas de circuits intégrés, notamment d'ASIC, cette source calorifique est habituellement située au centre des circuits.

La déformation 21 possède préférentiellement un rayon important. Ceci permet de centrer le point de contact 23 sur la puce 22. En pratique, l'écrasement de chaque déformation sur chaque composant permet d'obtenir une surface d'échange non réduite à un point. Il est possible d'obtenir une surface d'échange plus importante par l'utilisation d'une graisse conductrice entre la déformation 21 et le composant 11. Une surface plane au niveau du contact aurait en effet abouti à un contact non centré dû à un éventuel défaut de parallélisme entre la surface 26 du composant et la surface 23 du dissipateur. Un tel défaut de parallélisme peut notamment résulter d'un mauvais engagement du composant 11 dans les orifices de la carte 10.

Il est également possible d'intercaler un matériau souple thermiquement conducteur entre la déformation 21 et le composant 11 pour répartir de manière sensiblement uniforme la pression exercée par la déformation 21 sur la surface 26 du composant 11 et augmenter la surface d'échange. Ce matériau est par exemple un polymère chargé de matière conductrice.

Les déformations de la plaque 20 sont par exemple obtenues par emboutissage à l'aide d'outils présentant des rayons importants au niveau du point de contact avec le composant à refroidir, par exemple de l'ordre de 60 mm. Le contact thermique peut être amélioré par l'utilisation de graisse silicone disposée entre le composant et la surface de contact de la déformation. On obtient alors un contact thermique d'environ 1 centimètre carré de surface pour une épaisseur de graisse conductrice d'environ O,1 mm.

La figure 2 est une vue de dessus schématique d'une carte électronique 10 équipée d'un dissipateur thermique 20 selon l'invention. Le dissipateur thermique 20 recouvre une partie de la carte 10 comprenant trois composants 11, 36, 51 à refroidir. La zone de carte 10 non recouverte par la plaque 20 comprend des composants 43 à 47. La plaque 20 peut être fixée à l'aide des systèmes 33 et 34 de la figure 1. La plaque 20 comporte trois déformations 21,35 et 50 situées respectivement au-dessus des composants 11,36 et 51. Un contact optimal des déformations 21,35 et 50 avec les composants 11,36 et 51 est obtenu à l'aide des moyens de réglage 24,25,37,38,48 et 49, comprenant avantageusement chacun une rondelle élastique.

La plaque 20 comporte deux ouvertures 39 et 40 destinées à permettre le passage de composants 41,42 de taille plus importante que la hauteur des entretoises comprises dans les moyens de fixation 33,34 de la plaque 20.

On constate sur la figure 1 qu'il est possible de disposer des composants à proximité du composant à refroidir. Sur la figure 2, les composants 43 et 47 n'ont pas besoin d'être refroidis et la plaque 20 peut ne pas les recouvrir.

L'invention permet de refroidir efficacement les composants dissipant une énergie thermique importante, grâce à un contact direct entre les composants et la plaque. De plus, une plaque unique peut être utilisée pour tous les composants à refroidir, contrairement à l'état de la technique où chaque composant était muni d'un dissipateur. La dissipation est donc améliorée puisque la surface du dissipateur est plus importante.

Un contact thermique centré sur la source thermique d'un composant permet également de s'affranchir des éventuels problèmes de mauvais positionnement des composants. En effet, un contact thermique optimal est garanti même si le composant n'est pas correctement positionné, puisque la déformation sera toujours à proximité immédiate de la source calorifique si la surface supérieure du composant n'est pas parallèle au circuit imprimé.

Le réglage de la force de contact entre chaque composant et chaque déformation est aisé et réalisé indépendamment du nombre de composants à refroidir grâce à l'élasticité apportée par les rondelles élastiques. Enfin, le système n'utilise que des composants mécaniques courants, hormis le dissipateur thermique constitué par la plaque comportant une ou plusieurs déformations.

La surface de la plaque 20 est préférentiellement de taille importante et peut recouvrir la totalité du circuit imprimé 10 pour assurer une bonne dissipation de l'énergie calorifique.

Il est avantageux de relier le dissipateur 20 électriquement à la masse du dispositif présent sur la carte électronique. Le dissipateur contribue alors au blindage électromagnétique de la carte et comporte des parties latérales rabattues sur les côtés à angle droit vers la carte électronique et qui ne gênent pas la circulation de l'air, de façon à constituer une enceinte partiellement close pour les composants compris sur la carte.

Un autre avantage de l'invention est que l'on peut recouvrir toute la surface de la carte électronique et obtenir ainsi une surface de dissipation très importante.

## Revendications

1. Dissipateur thermique du type destiné à évacuer l'énergie calorifique dissipée par au moins un composant électronique (11, 36, 51) monté sur une carte (10), ledit dissipateur thermique étant constitué par une plaque (20) en matériau thermiquement conducteur destinée à être disposée au-dessus dudit composant (11, 36, 51) et fixée à l'aide de moyens (24, 25, 37, 38, 48, 49) de fixation à proximité dudit composant (11, 36, 51) pour presser ladite plaque contre ledit composant (11, 36, 51),
caractérisé en ce que ladite plaque (20) comporte une déformation par composant (11, 36, 51), chaque déformation (21, 35, 50) étant de forme sphérique et destinée à entrer en contact thermique avec la source calorifique du composant (11, 36, 51) correspondant.

2. Dissipateur thermique selon la revendication 1, caractérisé en ce que lesdites déformations (21, 35, 50) sont réalisées par emboutissages de ladite plaque (20).

3. Dissipateur thermique selon l'une des revendications 1 et 2, caractérisé en ce que lesdites déformations (21, 35, 50) ont un rayon de l'ordre de 60 mm.

4. Dissipateur thermique selon l'une des revendications 1 à 3, caractérisé en ce que lesdites déformations (21, 35, 50) coopèrent chacune avec une graisse conductrice pour obtenir une surface plus importante d'échange thermique entre la déformation (21, 35, 50) et le composant (11, 36, 51) correspondant.

5. Dissipateur thermique selon l'une des revendications 1 à 4, caractérisé en ce que les profondeurs (P) desdites déformations (21,35,50) sont fonction des hauteurs desdits composants (11, 36, 51).

6. Dissipateur thermique selon l'une des revendications 1 à 5, caractérisé en ce que lesdits moyens (24, 25, 37, 38, 48, 49) de fixation appliquent respectivement chacune desdites déformations (21, 35, 50) contre lesdits composants (11, 36, 51).

7. Dissipateur thermique selon l'une des revendications 1 à 6, caractérisé en ce que lesdites déformations (21, 35, 50) présentent des surfaces (23) de contact et d'échange thermique avec lesdits composants (11, 36, 51) correspondant aux surfaces des sources (22) calorifiques desdits composants (11, 36, 51).

8. Dissipateur thermique selon l'une des revendications 1 à 7, caractérisé en ce que lesdits moyens (24, 25, 37, 38, 48, 49) de fixation comportent un élément (29) élastique permettant d'assurer un contact thermique optimal entre lesdites déformations (21, 35, 50) et lesdits composants (11, 36, 51).

9. Dissipateur thermique selon l'une des revendications 1 à 8, caractérisé en ce qu'une couche de matériau thermiquement conducteur est placée entre lesdits composants (11, 36, 51) et lesdites déformations (21, 35, 50) pour répartir les pressions exercées par lesdites déformations (21, 35, 50) sur lesdits composants (11, 36, 51).

10. Dissipateur thermique selon l'une des revendications 1 à 9, caractérisé en ce que ladite plaque (20) est reliée électriquement à la masse du montage de ladite carte (10) pour constituer un blindage électromagnétique de ladite carte (10).

11. Dissipateur thermique selon l'une des revendications 1 à 10, caractérisé en ce que lesdits moyens de fixation (24, 25, 37, 38, 48, 49) sont solidaires de ladite carte (10).

12. Dissipateur thermique selon l'une des revendications 1 à 11, caractérisé en ce qu'il comporte au moins deux desdites déformations (21, 35, 50) chaque déformation étant destinée à entrer en contact thermique avec la source calorifique d'un composant (11, 36, 51).

## Patentansprüche

1. Kühlkörper, der die von mindestens einem auf einer Karte (10) installierten Elektronikbauteil (11, 36, 51) erzeugte Wärme ableiten soll und aus einer Platte (20) aus wärmeleitendem Material besteht, die über dem Bauteil (11, 36, 51) angeordnet und mit Hilfe von Befestigungsmittel (24, 25, 37, 38, 48, 49) in der Nähe des Bauteils (11, 36, 51) befestigt wird, die die Platte gegen das Bauteil (11, 36, 51) drücken, dadurch gekennzeichnet, daß die Platte (20) eine Vertiefung (21, 35, 50) je Bauteil (11, 36, 51) aufweist, die kugelförmig ist und mit der Wärmequelle des entsprechenden Bauteils (11, 36, 51) in Wärmekontakt treten soll.

2. Kühlkörper nach Anspruch 1, dadurch gekennzeichnet, daß die Vertiefungen (21, 35, 50) durch Prägen der Platte (20 hergestellt werden.

3. Kühlkörper nach einem der Ansprüche 1 und 2, dadurch gekennzeichnet, daß die Vertiefungen (21, 35, 50) eine Radius der Größenordnung von 60 mm haben.

4. Kühlkörper nach einem der Ansprüche 1 bis 3, dadurch gekennzeichnet, daß die Vertiefungen (21, 35, 50) je mit einem leitenden Fett zusammenwirken, um eine größere Oberfläche für den Wärmeaustausch zwischen der Vertiefung (21, 35, 50) und dem entsprechenden Bauteil (11, 36, 51) zu erhalten.

5. Kühlkörper nach einem der Ansprüche 1 bis 4, dadurch gekennzeichnet, daß die Tiefe (P) der Vertiefungen (21, 35, 50) von der Höhe der Bauteile (11, 36, 51) abhängt.

6. Kühlkörper nach einem der Ansprüche 1 bis 5, dadurch gekennzeichnet, daß die Befestigungsmittel (24, 25, 37, 38, 48, 49) jede der Vertiefungen (21, 35, 50) gegen die Bauteile (11, 36, 51) drücken.

7. Kühlkörper nach einem der Ansprüche 1 bis 6, dadurch gekennzeichnet, daß die Vertiefungen (21, 35, 51) Flächen (23) für den Kontakt und den Wärmeaustausch mit den Bauteilen (11, 36, 51) aufweisen, die den Oberflächen der Wärmequellen (22) der Bauteile (11, 36, 51) entsprechen.

8. Kühlkörper nach einem der Ansprüche 1 bis 7, dadurch gekennzeichnet, daß die Befestigungsmittel (24, 25, 37, 38, 48, 49) ein elastisches Element (29) aufweisen, das einen optimalen Wärmekontakt zwischen den Vertiefungen (21, 35, 50) und den Bauteilen (11, 36, 51) gewährleistet.

9. Kühlkörper nach einem der Ansprüche 1 bis 8, dadurch gekennzeichnet, daß eine Schicht aus wärmeleitendem Material zwischen den Bauteilen (11, 36, 51) und den Vertiefungen (21, 35, 50) liegt, die den durch die Vertiefungen (21, 35, 50) auf die Bauteile (11, 36, 51) ausgeübten Druck verteilt.

10. Kühlkörper nach einem der Ansprüche 1 bis 9, dadurch gekennzeichnet, daß die Platte (20) elektrisch mit der Masse der Schaltung auf der Karte (10) verbunden ist, um eine elektromagnetische Abschirmung der Karte (10) zu bilden.

11. Kühlkörper nach einem der Ansprüche 1 bis 10, dadurch gekennzeichnet, daß die Befestigungsmittel (24, 25, 37, 38, 48, 49) fest mit der Karte (10) verbunden sind.

12. Kühlkörper nach einem der Ansprüche 1 bis 11, dadurch gekennzeichnet, daß er mindestens zwei Vertiefungen (21, 35, 50) aufweist, die je mit der Wärmequelle eines Bauteils (11, 36, 51) in Wärmekontakt treten sollen.

## Claims

1. Heatsink of the type adapted to remove heat dissipated by at least one electronic component (11, 36, 51) mounted on a circuit board (10), said heatsink comprising a thermally conductive material plate (20) adapted to be disposed over said component (11, 36, 51) and attached by fixing means (24, 25, 37, 38, 48, 49) near said component (11, 36, 51), to press said plate against said component (11, 36, 51),
characterised in that said plate (20) comprises a deformation for each component (11, 36, 51), each deformation (21, 35, 50) being part-spherical and adapted to enter into thermal contact with the heat source of the corresponding component (11, 36, 51).

2. Heatsink according to claim 1 characterised in that said deformations (21, 35, 50) are formed by stamping said plate (20).

3. Heatsink according to claim 1 or claim 2 characterised in that said deformations (21, 35, 50) have a radius in the order of 60 mm.

4. Heatsink according to any one of claims 1 to 3 characterised in that said deformations (21, 35, 50) each cooperate with thermally conductive grease to achieve a larger area of heat exchange between the deformation (21, 35, 50) and the respective component (11, 36, 51).

5. Heatsink according to any one of claims 1 to 4 characterised in that the depths (P) of said deformations (21, 35, 50) are related to the height of said components (11, 36, 51).

6. Heatsink according to any one of claims 1 to 5 characterised in that said fixing means (24, 25, 37, 38, 48, 49) are adapted to apply each of said deformations (21, 35, 50) to said components (11, 36, 51).

7. Heatsink according to any one of claims 1 to 6 characterised in that said deformations (21, 35, 50) have heat exchange and contact surfaces (23) with said components (11, 36, 51) matched to the surface areas of the heat sources (22) of said components (11, 36, 51).

8. Heatsink according to any one of claims 1 to 7 characterised in that said fixing means (24, 25, 37, 38, 48, 49) comprise a spring member (29) adapted to provide optimum thermal contact between said deformations (21, 35, 50) and said components (11, 36, 51).

9. Heatsink according to any one of claims 1 to 8 characterised in that a layer of thermally conductive material is disposed between said components (11, 36, 51) and said deformations (21, 35, 50) to distribute substantially uniformly the pressure exerted by said deformations (21, 35, 50) on said components (11, 36, 51).

10. Heatsink according to any one of claims 1 to 9 characterised in that said plate (20) is connected electrically to the earthing point of the circuit on said circuit board (10) to constitute an electromagnetic screen for said board (10).

11. Heatsink according to any one of claims 1 to 10 characterised in that said fixing means (24, 25, 37, 38, 48, 49) are attached to said board (10).

12. Heatsink according to any one of claims 1 to 11 characterised in that it includes at least two of said deformations (21, 35, 50), each deformation being adapted to enter into thermal contact with the heat source of one component (11, 36, 51).
